# EUROPÄISCHE PATENTSCHRIFT

(11) **EP 2 606 273 B1**
(45) Veröffentlichungstag und Bekanntmachung des Hinweises auf die Patenterteilung: **08.06.2016**
(21) Anmeldenummer: 11748347.9
(22) Anmeldetag: 17.08.2011
(51) Int. Cl.: F21V 21/002, F21V 27/02, F21V 31/04, F21S 4/10, F21Y 115/10

(54) **GEHÄUSTES LED-MODUL**
PACKAGED LED MODULE
MODULE DEL ENCAPSULÉ

(30) Priorität: 03.02.2011 DE 102011003608; 20.08.2010 DE 102010039592
(43) Veröffentlichungstag der Anmeldung: 26.06.2013
(73) Patentinhaber: Tridonic Jennersdorf GmbH, 8380 Jennersdorf (AT); Tridonic GmbH & Co KG, 6851 Dornbirn (AT)
(72) Erfinder: PACHLER, Peter, A-8042 Graz (AT); DOBOS, Janos, H-9700 Szombathely (HU); PEINSIPP, Roland, A-8200 Gleisdorf (AT)
(74) Vertreter: Rupp, Christian
(86) Internationale Anmeldenummer: PCT/EP2011/064136
(87) Internationale Veröffentlichungsnummer: WO 2012/022760

(56) Entgegenhaltungen:
- DE-A1- 19 904 915
- DE-U1-202009 000 236
- US-A1- 2005 139 850
- US-A1- 2006 197 474

## Beschreibung

Die vorliegende Erfindung betrifft ein gehäustes LED-Modul für Leuchtdioden ('LEDs') mit integrierter Elektronik, welches eine flexible Montage der LEDs bzw. des Moduls ermöglicht und welches entsprechenden Schutz gegen Feuchtigkeit anbietet. Ferner betrifft die Erfindung ein Verfahren zur Herstellung eines gehäusten LED-Moduls, ein gehäustes LED-Modulsystem sowie eine LED-Kette mit wenigstens zwei erfindungsgemäßen gehäusten LED-Modulen.

Aus dem Stand der Technik sind LED-Module bekannt, welche im Wesentlichen aus einem Modul mit wenigstens einer darauf angebrachten LED bestehen. Die einzelnen Module einer LED-Kette werden dabei vorzugsweise parallel zueinander geschaltet.

DE 202009013278 U zeigt ein gehäustes LED-Modul mit einem mehrteiligen, verschließbaren Gehäuse, wobei das Gehäuse an einer Stirnseite mindestens zwei steife aus der Wand des Gehäuses nach außen stehende Leiter aufweist, die dazu ausgelegt sind, durch Einschneiden in die Isolierung mindestens zweier im Wesentlichen rechtwinkelig zugeführter Leiter diese elektrisch zu kontaktieren, wobei die elektrische Kontaktierung mittels eines zusätzlichen Montageadapters zugentlastet werden kann.

Die US 2006/0284199 A1 zeigt ein LED-Modul mit einem Gehäuse, eine mit dem Gehäuse lösbar verbindbare und das Gehäuse verschließende Wärmeleitplatte, einer mit der Wärmeleitplatte thermisch verbundenen Leiterplatte mit LED-Element sowie mehreren Anschlusskabeln.

Die DE 20200900236 U zeigt ebenfalls ein gehäustes LED-Modul, mit einem mehrteiligen, verschließbaren Gehäuse, welches seitliche Anschlussführungen für wenigstens zwei zur elektrischen Kontaktierung des Moduls verwendete Anschlusskabel als Zugentlastungselemente aufweist. Das Gehäuse weist seitliche Aussparungen für Anschlusskabel auf, wobei die Anschlussführungen zwei im Wesentlichen parallele Aussparungen sind, welche durch eine Verbindungskammer miteinander verbunden sind. Eine Verbindung zwischen der Verbindungskammer und einer zentralen Ausnehmung, in welcher das LED-Modul gelagert ist, besteht nicht. Dementsprechend ist die Verbindungskammer von der zentralen Ausnehmung und folglich auch von dem LED-Modul abgeschottet. Über eine Öffnung kann die Verbindungskammer sowie die Anschlussführungen mit einer flüssigen und/oder aushärtbaren Vergussmasse gefüllt werden.

DE 1 99 04 915 A1 offenbart ein LED Modul mit U-förmigem Gehäuse, in welchem wenigstens eine auf einem Träger aufgebrachte LED Lichtquelle angeordnet ist, wobei zur Verbindung zwischen dem Träger und dem U-förmigen Gehäuse ein Gußmaterial vorhanden ist. Ein zwischen Gehäuse und Träger angeordneter elastischer Dichtring umschließt die LED Lichtquelle und soll verhindern, dass Gußmaterial im flüssigen Zustand zwischen Lichtquelle und Gehäuse gelangt.

Die herkömmlichen LED-Kettenmodule weisen jedoch einen geringen Schutz gegen mechanische Beanspruchung sowie gegen Feuchtigkeit und eine geringe Flexibilität auf, was deren Einsatzmöglichkeiten einschränkt.

Ziel der vorliegenden Erfindung ist es daher, ein gehäustes LED-Modul bereitzustellen, welches einen effektiven Schutz gegen Umwelteinflüsse auf die LED und das Modul bei gleichzeitig kompakter und stabiler Bauweise ermöglicht sowie einfach und schnell herzustellen ist. Unter Schutz gegen Umwelteinflüsse sind hierbei einerseits Feuchtigkeitsschutz und Staubschutz als auch Schutz gegen mechanische Beanspruchung des LED-Moduls zu verstehen.

Die Aufgabe wird durch die Merkmale der unabhängigen Patentansprüche gelöst. Die abhängigen Ansprüche bilden den zentralen Gedanken der Erfindung in vorteilhafter Weise weiter.

Im Rahmen der Erfindung wird unter LED-Modul ein Träger oder eine Platine verstanden, welche wenigstens einen sich darauf befindlichen LED-Chip und die notwendige Ansteuerelektronik für den wenigstens einen LED-Chip umfasst. Dabei kann der wenigstens eine LED-Chip beispielsweise in COB (Chip On Board) oder SMD (Surface-Mounted Device) montiert sein.

Die vorliegenden Erfindung behandelt ein gehäustes LED-Modul, aufweisend ein Modul mit wenigstens einer darauf angeordneten LED, ein einteiliges Gehäuse mit einer Aufnahme für das Modul, einem im Wesentlichen optisch durchlässigen Bereich, welcher das Abstrahlen von Licht der LED nach außen ermöglicht und einer Öffnung, und ein Vergießblockiermittel, welches zwischen dem Modul und dem Gehäuse vorgesehen bzw. angeordnet ist, wobei das Vergießblockiermittel derart ausgebildet ist, dass es das Eindringen einer über die Öffnung in das mit dem Modul bestückte Gehäuse eingebrachten Vergussmasse (bspw. mittels eines Zwei- oder Mehrkomponenten-Spritzsystems) in einen Bereich zwischen LED und den im Wesentlichen optisch durchlässigen Bereich, durch Aufhebung der Kapillarwirkung zwischen Modul und Gehäuse verhindert.

Unter LED wird im Rahmen der Erfindung ein LED-Chip beschrieben. Dieser kann entweder 'face-up' oder 'face-down' auf dem Modul angeordnet sein. Zudem kann eine LED-Vergussmasse (die von der in das Gehäuse eingebrachten Vergussmasse zu unterscheiden ist) auf dem Modul angeordnet sein, welche den LED-Chip umgibt. Dementsprechend kann der LED-Chip von der LED-Vergussmasse eingekapselt sein. Die LED-Vergussmasse besteht vorzugsweise aus flüssigem Kunststoff und wird mithilfe eines Dispens-Verfahrens auf das Modul aufgetragen. Anstelle der LED-Vergussmasse oder zusätzlich dazu kann ein mechanischer Schutz der LEDs vorgesehen sein. Dieser kann direkt auf dem LED-Modul aufgebracht sein. Beispielsweise können sogenannte globe-tops, also durch Dispensen aufgebrachte LED-Vergussmassen, vorgesehen sein, welche die LED umgeben.

Die LED-Vergussmasse kann Farbkonversions- und/oder Streupartikel enthalten. Die LED(s) des LED-Moduls emittiert vorzugsweise Licht einer Wellenlänge zwischen 420-490nm. Durch die Farbkonversionspartikel, welche in der die LED umgebenden LED-Vergussmasse enthalten sind, wird das Licht wenigstens teilweise in Licht einer höheren Wellenlänge konvertiert. Die vorliegende Erfindung beschränkt sich nicht auf LEDs einer bestimmten Wellenlänge. Im Rahmen der Erfindung kann jede beliebige monochromatische LED auf dem LED-Modul angeordnet sein. Beispielsweise kann auch eine rot emittierende LED auf dem LED-Modul angeordnet sein, welche mit LED-Vergussmasse mit oder ohne Farbkonversionspartikeln umgeben ist. Zudem können LEDs, welche mit LED-Vergussmassen mit unterschiedlichen Farbkonversionspartikeln umschlossen sind, auf dem LED-Modul angeordnet sein.

Die LED-Vergussmasse ist vorzugweise kalottenförmig oder halbkugelförmig auf den LED-Chip aufgetragen.

Es ist jedoch auch möglich, dass Farbkonversionsmittel separat in dem Gehäuse des Moduls angeordnet sind. Dementsprechend kann eine LED-Vergussmasse mit Farbkonversionsmitteln räumlich getrennt von dem LED-Chip angeordnet sein.

Die Steuerelektronik des LED-Chips ist vorzugsweise auf der Rückseite des Moduls angebracht. Alternativ kann sie aber auch auf der gleichen Oberfläche wie der LED-Chip des Moduls angebracht sein. Sie kann sich auch zumindest teilweise innerhalb des Trägers bzw. der Platine des Moduls befinden. Die Steuerelektronik des Moduls umfasst dabei vorzugsweise eine Transistorschaltung oder weitere Elektronik und eine Schnittstelle für eine Kommunikationseinrichtung bzw. einen Kommunikationsbus. Weiterhin kann sie einen integrierten Schaltkreis aufweisen, vorzugsweise einen ASIC (Anwendungsspezifische Integrierte Schaltung). Außerdem ist denkbar, dass sie über eine Sensorik, wie beispielsweise einen Temperatur-, Helligkeits- oder Farbsensor, zur Überwachung des LED-Moduls verfügt.

Das Gehäuse des LED-Moduls ist erfindungsgemäß einteilig ausgebildet und weist eine Öffnung auf. Vorzugsweise ist das gehäuste LED-Modul wenigstens zu einer Seite hin bzw. auf einer Seite offen ausgebildet ist, wobei über diese Öffnung des Gehäuses sowohl die Vergussmasse in das Gehäuse eingebracht als auch das LED-Modul in das Gehäuse einfach eingesetzt werden kann.

Das Gehäuse ist erfindungsgemäß so ausgebildet, dass es nach dem Einlegen des LED-Moduls in die Aufnahme sogleich von hinten, also über die Öffnung, ausgegossen werden kann. Die Vergießblockiermittel erzielen insbesondere eine Unterbrechung bzw. Aufhebung der Kapillarwirkung zwischen dem in das Gehäuse eingelegtem Modul sowie dem Gehäuse, so dass die eingegossene Vergussmasse nicht aufgrund Kapillarwirkung in den Bereich zwischen LED und im Wesentlichen optisch durchlässigen Bereich eindringt. Somit wird weiterhin ein gezieltes Abstrahlen von Licht der LED nach außen ermöglicht. Die Verwendung der Vergießblockiermittel ermöglicht es auf besonders einfache Weise, dass das LED-Modul sowie auch mit dem Modul verbindbare Anschlusskabel im Gehäuse ohne die Verwendung von einem zusätzlichen Material, wie bspw. ein separates Dichtelement, nach außen abgedichtet und voll vergossen werden kann, ohne dass die Vergussmasse nach vorne zwischen LED und den im Wesentlichen optisch durchlässigen Bereich dringt. Auch auf zusätzlich Trennwände oder ähnliches kann verzichtet werden, die zu einer Vergrößerung des gesamten Bauteils führen würden.

Da das gehäuste LED-Modul voll vergossen werden kann, wird auch kein zusätzliches Unterteil zum Verschließen des Gehäuses benötigt, sei es nun eine zusätzliche Abdeckung oder eine integral mit dem Gehäuse ausgebildete, bspw. verschwenkbare Abdeckung.

Da das Gehäuse mit Modul direkt nach dem Einlegen des Moduls ausgegossen werden kann, kann auch auf die Verwendung eines doppelseitigen Montageklebebands für das Modul zu dessen Fixierung verzichtet werden.

Da der Vergusskörper sowohl die Anschlusskabel als auch die Verbindung zwischen Anschlusskabel und LED-Modul umschließt, wird auf diese Weise ebenfalls eine sichere Zugentlastung für die Anschlusskabel zur Verfügung gestellt. Auf die Kabel wirkende Zugkräfte werden somit sicher in den Vergusskörper und somit in das Gehäuse geleitet. Mit der erfindungsgemäßen Vorrichtung werden folglich sowohl die Herstellungs- und Montageschritte reduziert als auch die Herstellungskosten gesenkt, wobei gleichzeitig ein effektiver Schutz gegen Umwelteinflüsse auf die LED und das LED-Modul bei gleichzeitig kompakter und stabiler Bauweise ermöglicht wird.

Das LED-Modul ist auf diese Weise so konstruiert, dass es mehr als 60% der Betriebsspannung für die Lichterzeugung umsetzt. Beispielsweise bei der Verwendung von 3 LEDs in Serienschaltung mit 12V haben diese bei dem Betriebsstrom ca. 10-11V Vorwärtsspannung. Durch diese Verschaltung wird folglich das 83-91%ige der elektrischen Leistung für Lichterzeugung umgesetzt, wodurch eine optimale Lichtausbeute (1m/W) erreicht werden kann.

Vorteilhafter Weise bildet die eingebrachte Vergussmasse (nach dem Aushärten) einen Vergusskörper, der das Gehäuse, aufgrund der Vergießblockiermittel ausgenommen den Bereich zwischen LED und den im Wesentlichen optisch durchlässigen Bereich, vollständig ausfüllt und der das Gehäuse, das Modul sowie mit dem Modul verbindbare Anschlusskabel in nach außen abdichtender Weise verbindet. Das einteilige Gehäuse mit Modul sowie mit dem Modul verbindbare Anschlusskabel kann also vollständig ausgegossen werden und das Modul sowie die entsprechend in dem Gehäuse angeordneten Anschlusskabelbereiche können somit sicher vor Umwelteinflüssen in dem Gehäuse in nach außen abdichtender Weise integriert werden, wobei dennoch Vergießblockiermittel verhindern, dass lediglich ein Bereich zwischen der LED und den im Wesentlichen optisch durchlässigen Bereich mit Vergussmasse ausgefüllt wird.

Erfindungsgemäß sind die Vergießblockiermittel integraler Bestandteil des Moduls und/oder des Gehäuses. Die Vergießblockiermittel weisen eine Nut auf, welche auf der Innenseite des Gehäuses und um den im Wesentlichen optisch durchlässigen Bereich herum ausgebildet ist. Auf diese Weise wird der Bereich zwischen der LED und dem im Wesentlichen optisch durchlässigen Bereich des Gehäuses nicht mit Vergussmasse ausgefüllt, da durch die Nut die Kapillarwirkung zwischen Gehäuse und Modul unterbrochen bzw. aufgehoben wird und die Vergussmasse nicht in diesen Bereich eindringen kann. Die durch die Öffnung in das Gehäuse mit Modul eingebrachte Vergussmasse breitet sich folglich in dem gesamten Gehäuse aus, dringt jedoch nicht in den Bereich zwischen LED und den im Wesentlichen optisch durchlässigen Bereich des Gehäuses ein, da ein Einfließen in diesen Bereich aufgrund der umlaufenden Nut und folglich der Aufhebung der Kapillarwirkung unterbrochen ist. Somit wird mit besonders einfachen Mitteln und mit geringem Material- und Arbeitsaufwand ein Eindringen von Vergussmasse in den Abstrahlbereich der LED verhindert. Vorzugsweise liegt das Modul plan auf der die Nut aufweisenden Seite des Gehäuses auf. Dazu sind sowohl das Modul als auch die entsprechende Seite des Gehäuses vorzugsweise plan ausgebildet. Auf diese Weise kann ein Eindringen der Vergussmasse in den besagten Bereich zwischen LED und den im Wesentlichen optisch durchlässigen Bereich noch effektiver verhindert werden.

Vorzugsweise weist das Gehäuse bzw. der im Wesentlichen optisch durchlässigen Bereich mehrere im Wesentlichen optisch durchlässige Bereiche auf. Dabei kann die Nut um die Gesamtheit der im Wesentlichen optisch durchlässigen Bereiche herum ausgebildet sein. Alternativ sind die jeweiligen im Wesentlichen optisch durchlässigen Bereiche einzeln oder in Gruppen jeweils mit einem eigenen, unabhängigen Vergießblockierungsmittel versehen, das beispielsweise als umlaufende Nut ausgebildet jeweils um einen oder eine entsprechende Gruppe von im Wesentlichen optisch durchlässigen Bereichen herum ausgebildet ist.

Vorzugsweise sind die im Wesentlichen optisch durchlässigen Bereiche in einer linearen Anordnung vorgesehen oder wenigstens einer der im Wesentlichen optisch durchlässigen Bereiche kann zu wenigstens einem anderen im Wesentlichen optisch durchlässigen Bereich versetzt vorgesehen sein.

Vorzugsweise weist das Gehäuse ferner Positioniermittel als Aufnahme für das Modul auf, die derart mit Positioniermitteln des Moduls zusammenwirken, dass sie das Modul im Gehäuse befestigen und/oder zentrieren. Das Positioniermittel des Gehäuses weist hierzu wenigstens einen Platzierungsstift auf, welcher sich in das Gehäuse entgegen der Einsteckrichtung des Moduls erstreckt, und das Modul ist über korrespondierende Platzierungsöffnungen als Positioniermittel auf die Platzierungsstifte aufgesteckt. Auf diese Weise kann das Modul einfach im Gehäuse zentriert werden und die Positioniermittel dienen zugleich als Befestigung des Moduls im Gehäuse, so dass dieses bis zum Einbringen der Vergussmasse sicher und lagefixiert angeordnet ist.

Zum Herstellen einer kraft- und formschlüssigen Verbindung zwischen Gehäuse und Modul und um die Lagefixierung des Moduls zu verbessern und sicherzustellen, können die Positioniermittel des Gehäuses, also beispielsweise die Platzierungs stifte, mit aufgestecktem Modul verstemmt werden. Somit wird sicher vermieden, dass das in dem Gehäuse angeordnete Modul sich aus seiner vorbestimmten Lage löst.

Alternativ oder zusätzlich können die Positioniermittel des Gehäuses, beispielsweise die vorgenannten Platzierungsstifte, eine elektrische Verbindung zwischen dem Modul und wenigstens einem, vorzugsweise wenigstens zwei zur elektrischen Kontaktierung des Moduls verwendeten Anschlusskabel bereitstellen. Hierzu weisen die Positioniermittel vorzugsweise eine elektrisch leitfähige Oberfläche auf oder sind aus einem elektrisch leitfähigen Material hergestellt. Die mit den Positioniermitteln in Kontakt tretenden Bereiche der Platzierungsöffnungen des Moduls weisen dazu ebenfalls elektrisch leitfähige Verbindungen auf. Um einen Kontakt mit dem oder den Anschlusskabeln zu ermöglichen, weisen entweder die Platzierungsstifte an ihren den Anschlusskabeln zugewandten Ende Schneidklemmkontakte auf, oder die Anschlusskabel sind an entsprechenden Stellen abisoliert, so dass eine elektrische Verbindung durch einfachen Berührkontakt hergestellt wird. Diese Verbindung wird durch den Vergusskörper schließlich lagefixiert, welcher das Gehäuse ausfüllt und Gehäuse mit Modul und Anschlusskabeln abdichtend verbindet.

Vorzugsweise weist das Gehäuse ferner seitliche Anschlussführungen mit Ausnehmungen auf, in denen wenigstens ein, vorzugsweise wenigstens zwei zur elektrischen Kontaktierung des Moduls verwendete Anschlusskabel geführt sind. Die Ausnehmungen weisen vorzugsweise Verjüngungen auf, welche abschnittsweise den Durchmesser der Ausnehmung verkleinern. Besonders vorzugsweise sind die Verjüngungen als Dichtlippen der Ausnehmungen ausgebildet, in die das bzw. die Anschlusskabel eingepresst sind, um das bzw. die Anschlusskabel abdichtend in den Anschlussführungen zu fixieren. Ein zusätzliches Abdichtelement kann somit entfallen. Der Vergusskörper allein sowie auch unterstützt durch die Dichtlippen ermöglicht es somit, dass das LED-Modul in dem Gehäuse ohne die Verwendung von zusätzlichem Material abdichtend und sicher fixiert gelagert ist. Zudem dienen die Verjüngungen als zusätzliche Zugentlastung, so dass die auf das bzw. die Anschlusskabel wirkenden Zugkräfte sicher auf das Gehäuse übertragen werden können.

Das Modul kann ferner, bspw. auf seiner der LED abgewandten Seite, Kontaktierungselemente zur elektrischen Kontaktierung des Moduls mit Anschlusskabeln aufweisen. Dies insbesondere, wenn die Platzierungsstifte nicht zur elektrischen Kontaktierung zwischen Modul und Anschlusskabel dienen. Das Kontaktierungselement ist dazu vorzugsweise elektrisch leitfähig und kann aus einem Metall oder einer Metalllegierung bestehen. Die Kontaktierungselemente sind vorzugsweise als Schneidklemmkontakte, Piercingkontakte, Crimpkontakte oder dergleichen bekannte Kontaktierungselemente ausgebildet. Schneidklemmkontakte sind in der Regel derart ausgebildet, dass sie einen Schlitz aufweisen, in den der entsprechende Leiter eingeschoben wird. Der Schlitz weist eine solche Größe auf, dass beim Hineinschieben die Isolierung der Leitung durchschnitten wird. Somit kann ein elektrischer Kontakt mit der Leitung realisiert werden. Dabei hat der Schlitz vorzugsweise eine solche Breite, dass der Leiter, beispielsweise ein Draht oder Litzen, nicht angeschnitten wird. Somit kann durch einfaches Zusammenstecken bzw. Aufstecken der Anschlusskabel ein elektrischer Verbindungs- bzw. Steckkontakt hergestellt werden kann.

Besonders vorzugsweise weist die Vergussmasse ein Material mit hoher Wärmeleitfähigkeit auf, wie beispielsweise Polyurethan, Silikonharz, Epoxydharz oder dergleichen bekannte Materialien. Vorzugsweise weist die Vergussmasse ein Material mit hoher Wärmeleitfähigkeit auf, wobei die Wärmeleitfähigkeit vorzugsweise höher als 0,3 W/(m*K), besonders vorzugsweise höher als 0,5 W/(m*K) ist. Derartige Vergussmaterialien ermöglichen es, dass die Temperatur der LED im Inneren des Gehäuses trotz kleiner geometrischer Abmessungen des Gehäuses innerhalb vorgegebener Grenzen gehalten werden kann, wodurch die Lebensdauer des gehäusten LED-Moduls optimal eingestellt werden kann. Insbesondere mit den vorgenannten Materialien als Vergussmasse wird somit ein Material zur Verfügung gestellt, welches eine gute Beständigkeit gegen UV-Strahlung bietet, eine relativ hohe Wärmeleitfähigkeit aufweist und eine kurze Verarbeitungszeit zum Vergießen des Gehäuses mit Modul aufweist. Die vorgenannten Harze und sonstige Vergussmassen können beispielsweise mittels eines Zwei- oder Mehrkomponenten-Spritzsystems eingebracht bzw. eingespritzt werden.

Die Erfindung umfasst ferner ein Verfahren zur Herstellung eines gehäusten LED-Moduls, ein gehäustes LED-Modul-System, sowie eine LED-Kette mit wenigstens zwei der erfindungsgemäßen gehäusten LED-Module montiert auf Anschlusskabeln, vorzugsweise flexiblen Anschlusskabeln.

Im Folgenden wird anhand der Zeichnungen der begleitenden Figuren ein Ausführungsbeispiel des erfindungsgemäßen LED-Moduls beschrieben.
- Figur 1: zeigt eine Explosionszeichnung eines ersten Ausführungsbeispiels des erfindungsgemäßen LED-Moduls.
- Figur 2: zeigt eine perspektivische Unteransicht des Gehäuses des LED-Moduls nach Figur 1.
- Figur 3: zeigt eine Draufsicht auf das Gehäuse nach Figur 1.
- Figur 4A: zeigt eine Schnittansicht des Gehäuses durch die Linie A-A der Figur 3.
- Figur 4B.: zeigt eine Schnittansicht des Gehäuses durch die Linie B-B der Figur 3.
- Figur 4C: zeigt eine Schnittansicht des Gehäuses durch eine Linie C-C der Figur 3.
- Figur 5: zeigt eine Unteransicht des Gehäuses nach Figur 1.
- Figur 6: zeigt eine Teilschnittansicht des Gehäuses durch die Linie D-D der Figur 5.
- Figur 7: zeigt eine Seitenansicht des Gehäuses nach Figur 1.
- Figur 8: zeigt eine Detailansicht des Details X des Gehäuses nach Figur 7.
- Figur 9: zeigt eine perspektivische Ansicht eines erfindungsgemäßen Gehäuses gemäß einem zweiten Ausführungsbeispiel.

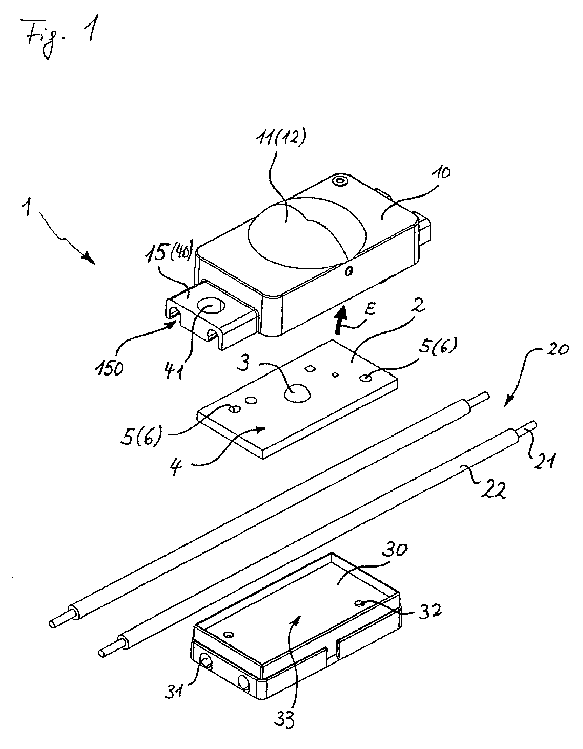

Figur 1 zeigt ein erfindungsgemäßes gehäustes LED-Modul 1 nach einer bevorzugten Ausführungsform in einer Explosionsansicht. Das erfindungsgemäße gehäuste LED-Modul 1 umfasst ein LED-Modul 2, im Folgenden auch als Modul bezeichnet, auf welchem wenigstens eine LED 3 aufgebracht bzw. angeordnet ist. Es ist jedoch eine beliebige Anzahl an LEDs 3, beispielsweise drei LEDs 3, möglich. Die LEDs 3 sind dann vorzugsweise parallel geschaltet. Das Modul 2 weist zudem eine Transistorschaltung oder weitere Schaltregler und eine Schnittstelle für eine Kommunikationseinrichtung auf. Die Oberfläche 4 des Moduls 2, auf welcher sich die LED 3 befindet, ist vorzugsweise reflektierend ausgestaltet. Hierzu kann beispielsweise weiße Farbe oder Lack auf dem Modul 2 aufgetragen sein. Es ist auch möglich, eine reflektierende Schicht, beispielsweise eine vorgefertigte Folie, auf das Modul 2 aufzubringen. Bei dem Modul 2 handelt es sich vorzugsweise um ein planes Modul. Die Elektronik des Moduls 2 ist vorzugsweise nur auf einer Oberfläche des Moduls 2 aufgebracht. Vorzugsweise ist die Elektronik auf der gleichen Seite wie der LED-Chip auf das Modul 2 aufgebracht.

Die LED-Chips können Face-Up oder Face-Down auf dem Modul 2 aufgebracht sein. Die LED-Chips können dabei von einer halbkugel- oder kalottenförmigen LED-Vergussmasse umgeben sein, in welcher Farbkonversionspartikel enthalten sein können. Die Farbkonversionsschicht wird dabei vorzugsweise in flüssigem Zustand mit Hilfe eines Dispensvorgangs auf die LED-Chips aufgebracht.

Anstelle der LED-Vergussmasse oder zusätzlich dazu kann ein mechanischer Schutz, beispielsweise ein sogenannter Globe-Top, über jedem der LED-Chips angeordnet sein. Das Globe-Top besteht vorzugsweise aus transparentem Kunststoff.

Die LEDs 3 können jede Art von monochromatischen LED-Chips, oder mit Farbkonversionsmittel bzw. Leuchtstoff konvertierte LEDs umfassen. Insbesondere können blau oder rot konvertierte LEDs auf dem LED-Modul 2 angeordnet sein.

Die Farbkonversionspartikel der LEDs 3 konvertieren dabei das von dem LED-Chip emittierte Licht wenigstens teilweise in Licht einer höheren Wellenlänge. Durch die von dem LED-Chip und von dem Farbkonversionspartikeln emittierten Lichtstrahlen wird vorzugsweise weißes Licht durch Additive Farbmischung erzeugt.

Das gehäuste LED-Modul 1 weist ferner ein einteiliges Gehäuse 10 auf. Vorzugsweise ist das Gehäuse 10 auf wenigstens einer Seite komplett oder wenigstens teilweise offen ausgebildet, um ein einfaches und sicheres Einsetzen des Moduls 2 in eine Aufnahme des Gehäuses 10 zu ermöglichen. Das Gehäuse 10 ist dann ein einteiliges, offenes Gehäuse. Das Gehäuse 10 ist vorzugsweise aus Kunststoff mit Hilfe eines Spritzgussverfahrens gefertigt.

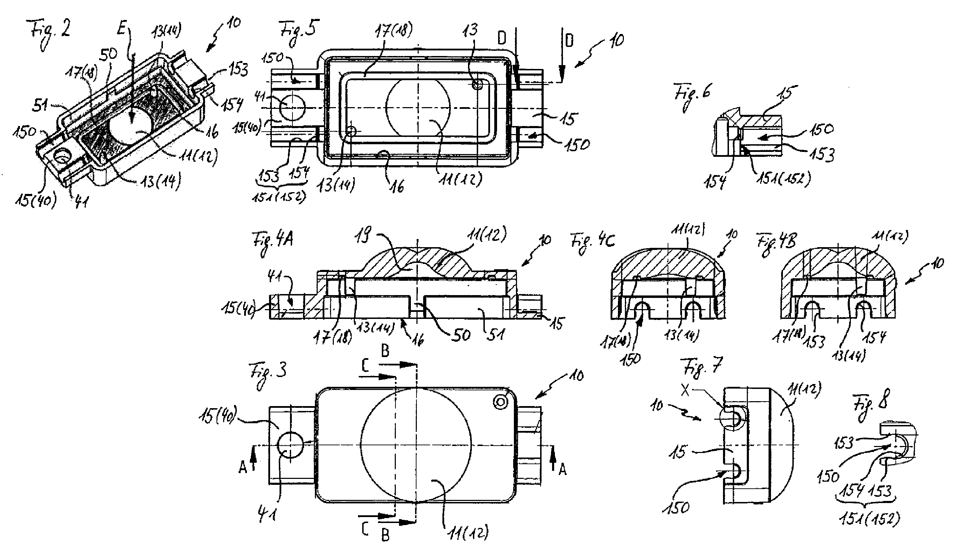

Das Gehäuse 10 weist einen im Wesentlichen optisch durchlässigen Bereich 11 auf, welcher das Abstrahlen von Licht der LED 3 nach außen ermöglicht. Gemäß dem Ausführungsbeispiel ist dazu das Gehäuse 10 wenigstens im Bereich der LED 3 transparent ausgebildet. In einer Ausführungsform kann das gesamte Gehäuse 10 transparent ausgebildet sein. Bevorzugt ist allerdings das nur der Bereich oberhalb der wenigstens einen LED 3 transparent gestaltet ist, während die anderen Bereiche des Gehäuses 10 durch andere Materialwahl, durch Oberflächenbearbeitung (Aufrauen, etc.) oder aber Lackieren intransparent ausgebildet sind. Somit kann die Elektronik auf dem Modul 2 von oben nicht einsehbar gemacht werden. Der im Wesentlichen optisch durchlässige Bereich 11 kann vorzugsweise als Linse 12 bzw. Kunststofflinse ausgebildet sein, insbesondere derart, dass sich der Bereich der wenigstens einen LED 3 über die Oberflächenkontur des Gehäuses 10 hinauswölbt, wie dies bspw. in den Figuren 4A-4C und 7 zu erkennen ist. Der optisch durchlässige Bereich 11 ist vorzugsweise koaxial mit der LED 3 angeordnet. Die Linse 12 kann dabei eine Streu-und/oder Beugefunktion aufweisen.

Bevorzugt kann der im Wesentlichen optisch durchlässige Bereich 11 eine die Lichtstrahlcharakteristik der LED 3 verändernde Funktion aufweisen. In einer bevorzugten Ausführungsform weist der optisch durchlässige Bereich 11 eine Streuwirkung, eine Reflektorwirkung und/oder eine Farbkonversionswirkung auf, welche die Lichtabstrahlcharakteristik der LED 3 verändert. Beispielsweise ist der optisch durchlässige Bereich 11 dazu wenigstens auf seiner Außenfläche und/oder Innenfläche strukturiert ausgebildet und somit diffus wirkend.

Das Modul 2 umfasst ferner Positioniermittel 5, welche eine richtige Positionierung, also Zentrierung und Befestigung, des Moduls 2 innerhalb des Gehäuses 10 ermöglichen. Die Positioniermittel 5 wirken vorzugsweise derart mit Positioniermitteln. 13 des Gehäuses 10 als Aufnahme für das Moduls 2 zusammen (vgl. Fig. 2), so dass sie das Modul 2 im Gehäuse 10 sicher befestigen und/oder zentrieren. Somit wird ein Verschieben des Moduls 2 im Inneren des Gehäuses 10 verhindert.

In einer bevorzugten Ausführungsform sind die Positioniermittel 13 an dem Gehäuse 10 angespritzt und greifen in Ausnehmungen oder Vertiefungen des Moduls 2 ein. Die Positioniermittel 13 umfassen dazu vorzugsweise wenigstens einen sich in das Gehäuse 10 und entgegen der Einsteckrichtung E des Moduls 2 erstreckenden bzw. hervorstehenden Platzierungsstift 14, bspw. einen Dorn oder Zapfen, welcher in einer entsprechenden Platzierungsöffnung 6 bzw. Aussparung als Positioniermittel 5 des Moduls 2 geführt wird bzw. aufgesteckt ist und vorzugsweise gehalten wird. Die Platzierungsstifte 13 unterscheiden sich dabei vorzugsweise in der Form und/oder Größe, so dass eine verwechslungsfreie Positionierung des Moduls 2 im Gehäuse 10 möglich ist. Dementsprechend kann die Platzierungsöffnung 6 hierfür eine entsprechende spezielle Form, beispielsweise Rechtecksform oder Dreiecksform, oder Größe aufweisen. Wenn die Positioniermittel 5, 13 also als miteinander korrespondierende, profilierte Elemente ausgebildet sind, kann das Modul 2 in das Gehäuse 10 definiert und in der richtigen Orientierung gelegt werden und eine genaue und korrekte Positionierung des Moduls 2 innerhalb des Gehäuses 10 wird somit ermöglicht. Somit können Fehler beim Einsetzen des Moduls 2 in das Gehäuse 10 vermieden werden. Die Positioniermittel 5,13 sind beispielsweise an diametral gegenübergesetzten Seiten des Gehäuses 10 angeordnet.

In einer bevorzugten Ausführungsform können die Positioniermittel 13 des Gehäuses 10, nachdem das Modul 2 entsprechend aufgesteckt worden ist, beispielsweise mechanisch oder durch Ultraschall verstemmt werden. Auf diese Weise kann eine kraft- und formschlüssige Verbindung zwischen Gehäuse 10 und Modul 2 sicher hergestellt werden, so dass das Modul 2 bereits vor einem Vergießen, welches im folgenden noch näher beschrieben wird, gehaltert ist.

Das Gehäuse 10 weist ferner vorzugsweise seitliche Anschlussführungen 15 für wenigstens eins vorzugsweise wenigstens zwei zur elektrischen Kontaktierung des Moduls 2 verwendete Anschlusskabel 20 auf, welche in den Anschlussführungen 15 geführt sind. Wenn im Folgenden der Einfachheit halber von Anschlusskabeln 20 im Plural die Rede ist, so sind damit alternativ sowohl ein einzelnes als auch mehrere Anschlusskabel gemeint; dasselbe gilt für den umgekehrten Fall, dass von Anschlusskabel 20 im Singular die Rede ist. Erfindungsgemäß sind somit Ausführungsbeispiel-übergreifen immer ein oder mehrere Anschlusskabel umfasst. Um eine elektrische Verbindung zwischen Modul 2 und Anschlusskabel 20 herzustellen, weist das Modul 20 vorzugsweise auf seiner der LED 3 abgewandten Seite Kontaktierungselemente (nicht gezeigt) zur elektrischen Kontaktierung des Moduls 2 mit dem Anschlusskabel 20 auf. Die Anordnung der Kontaktierungselemente ist jedoch durch die Erfindung nicht beschränkt. In einer bevorzugten Ausführungsform umfassen die Kontaktierungselemente Schneidklemmkontakte, so dass die Anschlusskabel 20 vor oder nach dem Einbringen des Moduls 2 in das Gehäuse 10 durch einfaches Aufstecken mit dem Modul 2 elektrisch kontaktiert werden können. Schneidklemmkontakte sind in der Regel derart ausgebildet, dass sie einen Schlitz aufweisen, in den der entsprechende Leiter 21 eingeschoben wird. Der Schlitz weist eine solche Größe auf, dass beim Hineinschieben die Isolierung 22 der Leitung 20 durchschnitten wird. Somit kann ein elektrischer Kontakt mit der Leitung 20 realisiert werden. Dabei hat der Schlitz vorzugsweise eine solche Breite, dass der Leiter 21, beispielsweise ein Draht oder Litzen, nicht angeschnitten wird, jedoch ein Klemmkontakt zwischen Schneidklemmkontakt und Leiter 21 erfolgt, so dass das Anschlusskabel 20 sicher im Kontaktierungselement gehalten wird. Neben Schneidklemmkontakten können auch andere bekannte Arten von Kontakten bereitgestellt sein, wie beispielsweise Piercingkontakte oder Crimpkontakte.

Anstelle der Kontaktierungselemente (bspw. Schneidklemmelemente) an dem Modul 2 kann eine elektrische Verbindung zwischen Modul 2 und Anschlusskabel 20 auch mittels Kontaktierungselementen an dem Gehäuse 10, also vorzugsweise mittels der Positionierelemente 13 des Gehäuses 10, erzielt werden. Dazu sind die Positionierelemente 13, vorzugsweise als Platzierungsstift 14 ausgebildet, beispielsweise mit einer elektrisch leitenden Schicht beschichtet oder als separate Teile aus einem elektrisch leitfähigen Material hergestellt und an der entsprechenden Position des Gehäuses 10 befestigt. Ein elektrischer Kontakt zu dem Modul 2 kann dann derart hergestellt werden, dass an den Kontaktbereichen zwischen dem Platzierungsstift 14 sowie den Platzierungsöffnung 6 des Moduls 2 beispielsweise in den Platzierungsöffnungen 6 entsprechende elektrische Kontaktbereiche oder Kontakte vorgesehen sind. Der elektrische Kontakt zu den Anschlusskabeln 20 kann derart hergestellt werden, dass entweder die Platzierungsstift 14 beispielsweise an ihren den Anschlusskabeln 20 zugewandten Enden Kontaktierungselemente (bspw. Schneidklemmelemente oder dergleichen) aufweisen, auf die die Anschlusskabel 20 einfach aufgesteckt werden können. Alternativ können die Anschlusskabel 20 auch an den entsprechenden Stellen abisoliert und mit den Enden der Platzierungsstift 14 in Kontakt gebracht werden, bevor eine Vergussmasse in das Gehäuse 10 eingebracht wird, was im weiteren noch näher beschrieben wird.

Wie zuvor beschrieben, weist das Gehäuse 10 eine oder vorzugsweise mehrere seitliche Anschlussführungen 15 auf, über die die Anschlusskabel 20 aus dem Gehäuse 10 geführt sind. Insbesondere mit Verweis auf die Figuren 5 bis 8 werden die Anschlussführungen 15 im Folgenden näher beschrieben.

Die Anschlussführungen 15 sind vorzugsweise einteilig mit dem Gehäuse 10 ausgebildet, vorzugsweise mit diesem zusammen in einem Spritzgießvorgang gespritzt.

Zur Aufnahme und Führung der Anschlusskabel 20 weist die Anschlussführung 15 jeweils wenigstens eine Anschlusskabelausnehmung 150, im Folgenden auch als Ausnehmungen bezeichnet, auf. Die Ausnehmungen 150 weisen vorzugsweise Verjüngungen 151 auf, welche Abschnittsweise den Durchmesser der Ausnehmung 150 verkleinern. Diese hervorstehenden Abschnitte, also die Verjüngungen 151, ermöglichen eine Klemmverbindung zwischen den Anschlusskabeln 20 und den Ausnehmungen 150 im zusammengesetzten Zustand mit dem Gehäuse 10. Vorzugsweise ist wenigstens eine Verjüngung 151 in jeder der vorzugsweise halbkreisförmig ausgebildeten Ausnehmungen 150 vorgesehen. Es können jedoch auch mehrere Verjüngungen 151 in jedem der vorzugsweise halbkreisförmig ausgebildeten Ausnehmungen 150 vorgesehen sein. Diese Verjüngungen 151 bilden Dichtlippen 152, die die Kabel an ihren Berührungsflächen sicher abdichten. Um ein sicheres Einpressen der Anschlusskabel 20 in die Ausnehmungen 150 zu gewährleisten, erstrecken sich die Verjüngungen 151 sowohl längs der Ausnehmung 150 in Form einer Längsverjüngung 153 als auch entlang ihrer halbkreisförmigen Oberflächenkontur in Form einer Konturverjüngung 154.

Auf diese Weise können die Anschlusskabel 20 in die Dichtlippen 152 der Ausnehmungen 150 eingepresst werden, um die Anschlusskabel 20 sicher abdichtend in den Anschlussführungen 15 zu fixieren.

Das Gehäuse 10 weist ferner eine Öffnung 16 auf, welche derart positioniert ist, dass sie im zusammengesetzten Zustand des Gehäuses 10 mit dem Modul 2 sowie den daran angeschlossenen Anschlusskabeln 20 einen Zugang zu dem Inneren des Gehäuses 10 ermöglicht. Über die Öffnung 16 kann im zusammengesetzten Zustand ein Einspritzmaterial bzw. eine Vergussmasse (bspw. mittels eines Zwei- oder Mehrkomponenten-Spritzsystems) in das mit dem Modul 20 bestückte Gehäuse 10 eingebracht werden. Vorzugsweise ist das Gehäuse 10 wenigstens auf einer Seite wenigstens teilweise offen. Gemäß dem Ausführungsbeispiel der Figuren (vgl. bspw. Figuren 2, 4A und 5) weist das Gehäuse 10 fünf, den Innenraum des Gehäuses 10 definierende Seitenwände auf, während eine Seite gänzlich offen ist. Diese offene Seite bildet die Öffnung 16, über die von hinten das Gehäuse 10 mit Modul 2 und Anschlusskabeln 20 ausgegossen werden kann. Über diese Öffnung kann vorzugsweise auch das Modul 2 in das Gehäuse 10 eingesetzt werden. Es ist jedoch auch denkbar, dass zum Einsetzen des Moduls 2 und zum Einbringen der Vergussmasse unterschiedliche Öffnungen vorgesehen sind und/oder die Öffnung 16 an einer anderen Seite und/oder nur in einem Bereich einer Seitenwand, beispielsweise als Loch oder Schlitz, gebildet ist.

Insbesondere die Öffnung 16 zum Einbringen der Vergussmasse sowie ggf. auch die Öffnung zum Einbringen des Moduls 2 in das Gehäuse 10 sind vorzugsweise auf einer dem im Wesentlichen optisch durchlässige Bereich 11 gegenüberliegenden Seite des Gehäuses 10 in dem Gehäuse 10 vorgesehen. Auf diese Weise kann die Vergussmasse beim Ausgießen des Gehäuses 10, was im weiteren noch näher beschrieben wird, durch das eingebrachte Vergussmaterial von hinten in seine Lageposition und sicher auf das Gehäuse 10 gedrückt werden.

Als Vergussmasse kommen beispielsweise flüssiger Kunststoff bzw. Epoxidmaterial zum Einsatz. Besonders vorzugsweise wird ein Material mit hoher Wärmeleitfähigkeit verwendet, wobei die Wärmeleitfähigkeit vorzugsweise höher als 0,3 W/(m*K), besonders vorzugsweise höher als 0,5 W/(m*K) ist. Besonders vorzugsweise werden Polyurethan, Silikonharz, Epoxydharz oder andere bekannte Materialien mit vorzugsweise hoher Wärmeleitfähigkeit als Vergussmasse verwendet. Mit dem Einbringen der Vergussmasse über die Öffnung 16 in das zusammengesetzte Gehäuse 10 verteilt sich die eingebrachte Vergussmasse in dem Gehäuse 10, was somit ausgegossen wird. Sowohl das Modul 2 als auch die Anschlusskabel 20, die in das Gehäuse 10 eingesetzt sind, werden dementsprechend von der eingebrachten Vergussmasse umgeben. Durch ein Trocknen bzw. Aushärten des eingebrachten Materials entsteht aus der Vergussmasse ein Vergusskörper 30 (vgl. Figur 1) und folglich eine Formschlussverbindung zwischen dem Gehäuse 10, dem Modul 2 sowie den Anschlusskabeln 20 des Moduls 2 mit dem Vergusskörper 30. Auf diese Weise ist sowohl mittels des Vergusskörpers 30 als auch mittels der Dichtlippen 152 das Innere des Gehäuses 10 sicher und auf abdichtende Weise vor Umwelteinflüssen wie beispielsweise Feuchtigkeit geschützt. Zudem kann auf zusätzliche Teile zum Verschließen des Gehäuses 10 sowie zum Vorsehen bzw. Anbringen des Moduls 2 in dem Gehäuse 10 verzichtet werden.

Des Weiteren dient, neben den Verjüngungen 151 der Ausnehmungen 150 der Anschlussführungen 15, auch der sich aus der Vergussmasse gebildete Vergusskörper 30 sicher als Zugentlastung für die Anschlusskabel 20, da dieser die Anschlusskabel 20 sicher und fest umschließt. Somit werden die auf die Anschlusskabel 20 wirkenden Zugkräfte besser sowohl auf das Gehäuse 10 als auch auf den Vergusskörper 30 übertragen, was die mechanische Widerstandsfähigkeit des LED-Moduls 2 und des gesamten gehäusten LED-Moduls 1 erhöht. Ein Trocknen bzw. Aushärten des aufgebrachten Materials ermöglicht folglich ein Abdichten des einzigen, einteiligen, offenen Gehäuses 10. Da somit alle Öffnungen sicher abgedichtet sind, ist das Gehäuse 10 des gehäusten LED-Moduls 1 gegen Umwelteinflüsse wie Staub, Schmutz und Feuchtigkeit geschützt. Durch die erfindungsgemäße Ausführung des Gehäuses 10 wird folglich ein Staub- und Feuchtigkeisschutz der Norm IP67 erzielt. Zudem kann auf zusätzliche oder einteilig und beweglich mit dem Gehäuse ausgebildete Teile, wie bspw. eine Abdeckung zum Verschließen des Gehäuses, verzichtet werden.

Durch die Zugentlastung der Anschlusskabel 20 wird zudem eine widerstandsfähige Verkettung von mehreren erfindungsgemäßen LED-Modulen zu einer LED-Kette ermöglicht.

Erfindungsgemäß weist das gehäuste LED-Modul 1 Vergießblockiermittel 17 auf, welche zwischen Modul 2 und dem Gehäuse 10 vorgesehen bzw. angeordnet sind. Dabei können die Vergießblockiermittel 17 integraler Bestandteil des Moduls 2 und/oder des Gehäuses 10 sein. Wie insbesondere der bevorzugten Ausführungsform der Figuren 2 und 5 zu entnehmen ist, weist das Gehäuse 10 die Vergießblockierungsmittel 17 auf. Es ist jedoch gemäß einer anderen Ausführungsform auch möglich, dass die Vergießblockierungsmittel 17 an entsprechender Position an dem Modul 2 oder auch separat von dem Gehäuse 10 und/oder Modul 2 zwischen diesen vorgesehen sind. Gemäß einer wieder anderen Ausführungsform können auch sowohl auf dem Gehäuse 10 als auch auf dem Modul 2 jeweils Vergießblockierungsmittel 17 vorgesehen sein, wobei diese miteinander korrespondieren können oder räumlich voneinander getrennt ausgebildet sein können. Auch ist es denkbar, dass mehr als ein Vergießblockierungsmittel 17 auf dem Gehäuse 10 bzw. dem Modul 2 vorgesehen ist.

Die Vergießblockierungsmittel 17 sind derart ausgebildet, dass sie eine Kapillarwirkung zwischen Modul 2 und Gehäuse 10 unterbrechen. Diese Vergießblockierungsmittel 17 weisen dazu vorzugsweise eine Nut 18 auf, welche vorzugsweise auf der Innenseite des Gehäuses 10 und um den im Wesentlichen optisch durchlässigen Bereich 11 herum ausgebildet ist. Dabei bildet das Vergießblockiermittel 17 insbesondere eine umlaufende Nut 18 aus. Sind mehr als ein Vergießblockierungsmittel 17 vorgesehen, so sind diese jeweils um den im Wesentlichen optisch durchlässigen Bereich 11 sowie um die jeweils anderen Vergießblockierungsmittel 17 herum ausgebildet, vorzugsweise konzentrisch umeinander herum. Das oder die Vergießblockierungsmittel 17 sind vorzugsweise koaxial um den im Wesentlichen optisch durchlässigen Bereich 11 sowie ggf. auch um einander herum angeordnet, wobei die Symmetrieachse vorzugsweise im Zentrum des im Wesentlichen optisch durchlässigen Bereichs 11 bzw. des Gehäuses 10 liegt.

Durch diese Vergießblockiermittel 17 wird erzielt, dass beim Einbringen der Vergussmasse über die Öffnung 16 die Kapillarwirkung zwischen dem Modul 2 und dem Gehäuse 10 in diesem Bereich unterbrochen wird und sich die Vergussmasse somit nicht in einem Bereich 19 zwischen der LED 3 und dem im Wesentlichen optisch durchlässigen Bereich 11 ausbreitet. Der Bereich 19 entspricht dabei also einem Lichtabstrahlbereich des LED-Moduls 1. Vorteilhafterweise liegt dazu das Modul 2 plan auf der Innenseite des Gehäuses 10 auf. Folglich wird das Innere des Gehäuses 10, ausgenommen der Bereich 19 zwischen LED 3 und dem im Wesentlichen optisch durchlässigen Bereich 11, vollständig ausgegossen, wobei eben im vorgenannten Bereich 19 kein Vergussmaterial eindringt. Auf diese Weise kann auf zusätzliche Trennwände und, dadurch hervorgerufen, eine Vergrößerung des Gehäuses 10 an sich verzichtet werden, sodass das gehäuste LED-Modul 1 insgesamt kleiner ausgebildet werden kann. Des Weiteren kann das Gehäuse 10 direkt nach dem Einsetzen des Moduls 2 sofort von hinten ausgegossen werden. Die Verwendung der Nut 18 für das Modul 2 sowie die Dichtlippen 152 für die Anschlusskabel 20 haben folglich den Vorteil, dass ohne Verwendung von weiteren Materialien das Gehäuse voll vergossen werden kann, wobei ein Eindringen in den Bereich 19 sicher vermieden wird. Da das Modul 2 voll vergossen werden kann, kann auch auf ein zusätzliches Unterteil für die Montage von einem doppelseitigen Montageklebeband für das Modul 2 verzichtet werden.

Ist die Öffnung 16 zum Einbringen der Vergussmasse auf der dem im Wesentlichen optisch durchlässige Bereich 11 gegenüberliegenden Seite des Gehäuses 10 in dem Gehäuse 10 vorgesehen, so kann das Modul 2, insbesondere bei planer Ausbildung desselben sowie der entsprechenden Gehäuseseite, beim Eingießen der Vergussmasse in Einsteckrichtung E des Moduls 2 und folglich auf das Gehäuse 10 gedrückt werden. Das Modul 2 wird also auf die Seite des Gehäuses 10 gedrückt, auf der der im Wesentlichen optisch durchlässigen Bereich 11 sowie das Vergießblockiermittel 17 vorgesehen sind. Somit wird, da das Modul 2 gegen die vorgenannte Seite des Gehäuses 10 gedrückt wird, das Eindringen von Vergussmasse in den Bereich zwischen LED 3 und den im Wesentlichen optisch durchlässigen Bereich 11, neben der Wirkung der Vergießblockiermittel 17 zum Unterbrechen der Kapillarwirkung zwischen Modul 2 und Gehäuse 10, zusätzlich unterdrückt bzw. erschwert. Außerdem kann zudem eine zusätzlich Befestigung des Moduls auf dem Gehäuse 10 und vor dem Ausgießen verzichtet werden, so dass das Gehäuse 10 direkt nach dem Einsetzen des Moduls 2 mit Anschlusskabeln 20 von hinten sicher, schnell und einfach ausgegossen werden.

Wird als Vergussmasse vorzugsweise Polyurethan verwendet, so kann das gehäuste LED-Modul 1 insgesamt besonders klein ausgebildet werden, da das Polyurethan eine besonders hohe Wärmeleitfähigkeit aufweist, was eine gute Temperaturabführung von der LED 3 bzw. dem Modul 2 ermöglicht, wodurch die geometrischen Abmessungen des Gehäuses 10 besonders klein gehalten werden können, während dennoch ein für das Modul 2 sicherer Temperaturbereich eingehalten werden kann. Das Polyurethan weist zudem eine gute Beständigkeit gegen UV-Strahlung auf und ermöglicht des Weiteren eine relativ kurze Verarbeitungszeit bei dem Gießvorgang.

Der aus der Vergussmasse sich bildende Vergusskörper 30 verbindet folglich das Gehäuse 10, das Modul 2 sowie mit dem Modul 2 verbundene Anschlusskabel 20 in nach außen abdichtender und lagefixierter Weise, wodurch ohne zusätzlich Bauteile und in besonders einfacher Weise ein kompaktes, stabiles und gegen Umwelteinflüsse sicher abgedichtetes und geschütztes gehäustes LED-Modul 1 zur Verfügung gestellt wird. In Figur 1 ist der Vergusskörper 30 dargestellt. Es ist dabei deutlich zu erkennen, dass der Vergusskörper 30 ein Abbild des Hohlraumes des Inneren des Gehäuses 10 mit eingelegtem Modul 2 und Anschlusskabeln 20 ist. So sind bspw. die die Anschlusskabel 20 umschließenden Bereiche 31 sowie die Bereiche 32, durch die sich die Platzierungsstifte erstrecken, erkennbar. Ebenso ist zu erkennen, dass in einem Bereich 33 entsprechend dem Bereich 19 kein Vergussmaterial vorhanden ist. Dies ist auf die Vergießblockiermittel 17 zurückzuführen, die durch Unterdrückung der Kapillarwirkung zwischen Modul 2 und Gehäuse 10 ein Eindringen von Vergussmasse verhindert haben, so dass in dem Bereich 19 zwischen LED 3 und im Wesentlichen optisch durchlässigen Bereich 11 kein Vergussmasse vorhanden ist.

Wie Figur 2 und 4A zu entnehmen ist, weist das Gehäuse 10 eine profilierte Oberfläche auf. Gemäß den Figuren kann diese bspw. mittels Stegen 50 bzw. Aussparungen 51 erzielt werden. Die Profilierungen können derart ausgebildet sein, dass der Vergusskörper 30 nach dem Aushärten entweder unlösbar mit dem Gehäuse 10 verbunden ist, beispielsweise durch Vorsehen von Hinterschneidungen in dem Gehäuse 10. Andererseits ist es denkbar, dass der Vergusskörpers 30 aufgrund der Profilierung und einer damit einhergehenden Vergrößerung der Oberfläche zum einen sicher in dem Gehäuse 10 gehalten wird, aufgrund der Ausgestaltung der Profilierung, bspw. mittels Schrägen, der Vergusskörper 30 dennoch vergleichsweise einfach wieder aus dem Gehäuse gelöst werden kann.

Wie insbesondere Figuren 1, 3 und 5 zu entnehmen ist, weist das Gehäuse 10 ferner vorzugsweise Befestigungsanschläge 40 auf, welche vorteilhafterweise mit Hilfe des Spritzgussverfahrens an das Gehäuse 10 angegossen sind. Die Befestigungsanschläge 40 weisen eine zentrale Bohrung 41 auf, welche die Befestigung des Gehäuses 10 mit Hilfe von Schrauben auf externen Oberflächen ermöglicht. Besonders vorzugsweise entspricht der Befestigungsanschlag 40 der Anschlussführung 15, wodurch das Gehäuse 10 noch kompakter ausgebildet werden kann. In diesem Fall erstreckt sich die Bohrung 41 vorzugsweise zwischen den Ausnehmungen 150 durch die Anschlussführung 15 hindurch, wenigstens jedoch auf eine solche Weise, dass sie die Ausnehmungen 150 nicht schneidet.

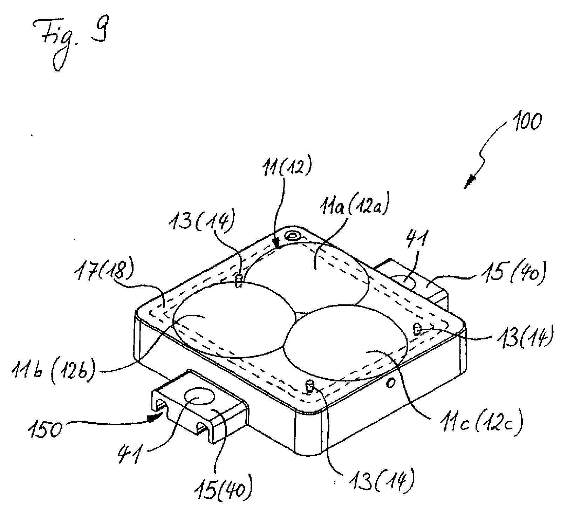

Figur 9 zeigt eine weitere Ausführungsform eines erfindungsgemäßen gehäusten LED-Moduls, genauer eines erfindungsgemäßen Gehäuses 100. Das erfindungsgemäße gehäuste LED-Modul gemäß der zweiten Ausführungsform umfasst dabei alle Merkmale gemäß dem ersten Ausführungsbeispiel, so dass zur Vermeidung von Wiederholungen vollumfänglich auf obige Ausführungen verwiesen wird. Gleiche Bezugszeichen entsprechen dabei gleichen Merkmalen. Im Folgenden sollen nun die wesentlichen Unterschiede zum ersten Ausführungsbeispiel dargestellt werden.

Es wurde bereits gesagt, dass auf einem LED-Modul eine beliebige Anzahl an LEDs aufgebracht bzw. angeordnet sein kann. Figur 9 zeigt nunmehr ein Ausführungsbeispiel eines einteiligen, offenen Gehäuses 100 eines erfindungsgemäßen gehäusten LED-Moduls, welches für ein LED-Modul mit drei LEDs ausgelegt ist. Die Erfindung ist jedoch, wie bereits erwähnt, nicht auf diese Anzahl beschränkt. Vorzugsweise weist das Gehäuse 100 bzw. der im Wesentlichen optisch durchlässigen Bereich 11 des Gehäuses 100 eine entsprechend der vorgesehenen Anzahl an LEDs ebenso entsprechenden Anzahl an im Wesentlichen optisch durchlässigen (Teil-)Bereichen 11a, 11b, 11c auf, die besonders vorzugsweise als Linse 12a, 12b, 12c bzw. Kunststofflinse ausgebildet sein können, insbesondere derart, dass sich der Bereich der jeweiligen LED über die Oberflächenkontur des Gehäuses 100 hinauswölbt. Der jeweilige optisch durchlässige Bereich 11a, 11b, 11c ist vorzugsweise koaxial mit der entsprechenden LED angeordnet.

Gemäß einer Ausgestaltungsform können die im Wesentlichen optisch durchlässigen Bereiche 11a, 11b, 11c in einer linearen Anordnung, vorzugsweise entlang der in den Anschlussführungen 15 geführten Anschlusskabel 20 vorgesehen sein. Wie jedoch auch dem Ausführungsbeispiel der Figur 9 zu entnehmen ist, kann bei mehreren im Wesentlichen optisch durchlässigen Bereichen 11a, 11b, 11c auch wenigstens einer seitlich zu den anderen versetzt vorgesehen sein. Wie dieser Versatz ausgebildet ist (Richtung, Dimension, etc.), ist dabei beliebig. Gemäß Figur 9 sind beispielsweise zwei Lichtpunkte bzw. im Wesentlichen optisch durchlässige Bereiche 11a, 11b versetzt zu einem dritten Lichtpunkt bzw. im Wesentlichen optisch durchlässige Bereiche 11c angeordnet, so dass die drei im Wesentlichen optisch durchlässigen Bereich 11a, 11b, 11c in einer Dreiecksform auf dem Gehäuse 100 ausgebildet sind.

Die Erfindung ist jedoch weder auf die Anzahl der im Wesentlichen optisch durchlässigen Bereiche 11a, 11b, 11c noch auf deren Größe oder Anordnung zueinander beschränkt.

Es ist darüber hinaus beispielsweise denkbar, dass jedem im Wesentlichen optisch durchlässigen Bereich 11a, 11b, 11c eine andersfarbige LED zugeordnet ist und/oder die im Wesentlichen optisch durchlässigen Bereiche 11a, 11b, 11c unterschiedliche Funktionen im Hinblick auf Streuwirkung, Reflektorwirkung und/oder Farbkonversionswirkung haben, welche die Lichtabstrahlcharakteristik der zugeordneten LED entsprechend verändert.

Ferner ist denkbar, dass einem im Wesentlichen optisch durchlässigen Bereich 11a, 11b, 11c mehrere LEDs gleicher oder unterschiedlicher Farbe zugeordnet sind. Dies gilt in gleicher Weise für das erste Ausführungsbeispiel.

Wie Figur 9 zu entnehmen ist, weist auch das Gehäuse 100 Vergießblockierungsmittel 17 zum Unterbrechen einer Kapillarwirkung zwischen Modul und Gehäuse 100 auf, die vorzugsweise eine Nut 18 aufweisen, welche ferner vorzugsweise auf der Innenseite des Gehäuses 100 und um die Gesamtheit der im Wesentlichen optisch durchlässigen Bereich 11a, 11b, 11c herum ausgebildet ist. Somit breitet sich die Vergussmasse nicht in einem Lichtabstrahlbereich zwischen den LEDs und den im Wesentlichen optisch durchlässigen Bereichen 11a, 11b, 11c aus. In Weiterbildung dieses gezeigten Ausführungsbeispiels ist es auch denkbar, dass die jeweiligen im Wesentlichen optisch durchlässigen Bereiche 11a, 11b, 11c einzeln oder in Gruppen jeweils mit einem eigenen, unabhängigen Vergießblockierungsmittel 17 versehen sind, das beispielsweise als umlaufende Nut 18 ausgebildet jeweils einen oder eine entsprechende Gruppe von im Wesentlichen optisch durchlässigen Bereichen 11a, 11b, 11c in zuvor beschriebener Weise umgibt.

Ebenso weist auch das Gehäuse 100 des Ausführungsbeispiels gemäß Figur 9 Positioniermittel 13 auf, die in bereits zuvor beschriebener Weise mit korrespondierenden Positioniermitteln des Moduls zusammenwirken. Die Positioniermittel 13 können, wie dargestellt, als Platzierungsstifte 14 ausgebildet sein, wohingegen die Positioniermittel des Moduls als Platzierungsöffnungen bzw.

Aussparungen vorgesehen sein können. Im gezeigten Beispiel sind drei Platzierungsstifte 14 vorgesehen, die in spiegelverkehrter Weise zu den im Wesentlichen optisch durchlässigen Bereichen 11a, 11b, 11c in einer Dreiecksform angeordnet sind und somit vorzugsweise in Bereichen vorgesehen sind, in denen keine im Wesentlichen optisch durchlässigen Bereiche 11a, 11 b, 11c vorhanden sind. Die Anzahl und Position der Positioniermittel 5, 13 bzw. Platzierungsöffnungen 6 und Platzierungsstifte 14 ist jedoch nicht durch die Erfindung beschränkt und können daher je nach Größe und Geometrie des Gehäuses bzw. des gehäusten LED-Moduls beliebig vorgesehen sein.

Vorzugsweise kann erfindungsgemäß eine LED-Kette gebildet werden, indem auf den Anschlusskabeln 20 an beliebigen Positionen mehrere erfindungsgemäße gehäuste LED-Module 1 einfach angeordnet und montiert werden. Die Anschlusskabel 20 zwischen den gehäusten LED-Modulen 1 sind Leitungen ohne Unterbrechung, die bei den Kontaktstellen entweder abisoliert oder mit Schneidklemmkontakten kontaktiert werden, ohne das Endloskabel zu unterbrechen. Diese Lösung ermöglicht eine endlose Verkettung sowie die Verwendung von vorprogrammierbaren, beliebig änderbaren Modulabständen auch innerhalb der LED-Kette. Durch Verwendung von flexiblen Anschlusskabeln 20 kann der Einsatzbereich, im Vergleich zu starren Leitern, noch vergrößert werden. Somit ist eine unendliche Anzahl an möglichen Abständen (gleichmäßig; ungleichmäßig; sich wiederholend) der erfindungsgemäßen LED-Module 1 auf einem Anschlusskabel 20 gegeben, welche durch das Vergießen des Vergusskörpers einfach hergestellt werden können. Ebenso ist durch die mögliche Verwendung von Endloskabeln jede beliebige Kettenlänge möglich, die zudem bei flexiblen Anschlusskabeln auch jede beliebige Form annehmen können.

Im Folgenden wird ein Verfahren zur Herstellung eines gehäusten LED-Moduls 1 beschrieben.

In einem ersten Schritt wird ein Modul 2 mit einer wenigstens darauf angeordneten LED 3 in eine Aufnahme eines einteiligen, vorzugsweise wenigstens an einer Seite offenen Gehäuses 10, 100 eingebracht. Das Gehäuse 10, 100 weist dabei den im Wesentlichen optisch durchlässigen Bereich 11, 11a, 11b, 11c und die Öffnung 16 auf. Das Modul 2 kann entweder über die Öffnung 16 oder eine separate Öffnung in das Gehäuse 10, 100 bzw. dessen Aufnahme eingesetzt werden. Die Aufnahme des Gehäuses 10, 100 kann dabei, wie zuvor beschrieben, durch entsprechende Positioniermittel 5, 13 des Moduls 2 und des Gehäuses 10, 100, die entsprechend zusammenwirken, ausgebildet sein, wobei beispielsweise das Positioniermittel 13 des Gehäuses 10, 100 als Platzierungsstift 14 ausgebildet sein kann, welches in Platzierungsöffnungen 6 des Moduls 2 eingesteckt wird, um das Modul 2 in dem Gehäuse 10, 100 zu befestigen und/oder zu zentrieren. Durch eine profilierte Ausgestaltung der Positioniermittel 5, 13 kann eine korrekte Ausrichtung des Moduls 2 sichergestellt werden. Ferner können Profilelemente in dem Gehäuse 10, 100 vorgesehen sein, die ebenfalls eine exakte Positionierung und verschiebungsfreie Lagerung des Moduls 2 innerhalb des Gehäuses 10, 100 gewährleisten.

Um das Modul 2 sicher in dem Gehäuse 10,100 zu befestigen, können die Platzierungsstifte 14 des Gehäuses 10, 100 nach dem Einsetzen des Moduls 2 in das Gehäuse 10, 100 verstemmt werden, um eine kraft- und formschlüssige Verbindung zwischen Gehäuse 10, 100 und Modul 2 herzustellen.

In einem weiteren Schritt werden die Anschlusskabel 20 (es kann sich dabei um ein oder mehrere Anschlusskabel handeln) mit dem Modul 2 verbunden. Dazu kann das Modul 2 vorzugsweise auf seiner dem LED 3 abgewandten Seiten (oder auch jeder anderen gewünschten Seite) mit Kontaktierungselementen, beispielsweise Schneidklemmkontakten, vorgesehen sein, in die die Anschlusskabel 20 einfach eingesteckt werden können und somit eine elektrische Verbindung hergestellt ist. Alternativ können auch die Platzierungsstifte 14 zur elektrischen Verbindung zwischen Modul 2 und Anschlusskabel 20 in vorbeschriebener Weise ausgebildet sein. Es ist auch denkbar, dass mehrere Platzierungsstifte 14 in Platzierungsöffnungen 6 eingesteckt sind, wobei ein Teil der Platzierungsstifte 14 nach dem Einsetzen des Moduls 2 verstemmt werden, während der andere Teil der Platzierungsstifte 14 mit Kontaktierungselementen versehen ist, um einen elektrischen Kontakt zwischen Modul 2 und Anschlusskabel 20 herzustellen.

Die Anschlusskabel 20 können ferner in Ausnehmungen 150 seitlicher Anschlussführungen 15 des Gehäuses 10, 100 eingebracht werden, wobei die Ausnehmungen 150 mit Verjüngungen 151, beispielsweise in Form von Dichtlippen, aufweisen, in die die Anschlusskabel 20 vor dem Einbringen der Vergussmasse eingepresst werden können. Auf diese Weise können die Anschlusskabel 20 in abdichtender Weise an dem Gehäuse 10, 100 fixiert werden, wobei die Verjüngungen 151 zusätzlich eine Zugentlastung für die Anschlusskabel 20 bilden. Zudem können die Anschlusskabel 20 auch relativ zu den Kontaktierungselementen des Moduls 2 bzw. der Platzierungsstifte 14 lagefixiert werden.

In einem weiteren Schritt wird sodann eine Vergussmasse über eine Öffnung 16 des Gehäuses 10, 100 in das mit dem Modul 2 bestückte Gehäuse 10, 100 eingebracht. Hierzu wird die Vergussmasse vorzugsweise über die Öffnung mittels eines Spritzsystems eingespritzt. Das Spritzsystem ist vorzugsweise ein Zwei- oder Mehrkomponenten-Spritzsystem, wobei die zu vermischenden Komponenten der Vergussmasse entweder vor dem Einbringen vermischt und dann über eine einzige Düse eingespritzt werden oder aber über zwei oder mehr Düsen eingespritzt werden, wobei die beiden Strahlen zusammenkommen und sich vorzugsweise vor Erreichen des Zieles, also dem Gehäuse 10, 100, oder an ihrem Bestimmungsort mischen. Die Erfindung ist jedoch nicht auf die vorbeschriebenen Systeme zum Einbringen der Vergussmasse beschränkt. Vielmehr sind alle bekannten Verfahren zum Einbringen einer Vergussmasse von der Erfindung mit umfasst.

Die Öffnung 16 kann dabei die gleiche sein wie die, über die das Modul 2 in das Gehäuse 10, 100 eingesetzt wurde. Die Öffnung 16 kann durch eine ganz oder teilweise offene Seite des Gehäuses 10, 100 gebildet sein. Da das Gehäuse 10, 100 ferner mit zuvor beschriebenen Vergießblockiermitteln 17 zwischen dem Modul 2 und dem Gehäuse 10, 100 versehen ist, wird das gesamte Gehäuse 10, 100 mit Modul 2 sowie Anschlusskabeln 20 innen vollständig ausgegossen bzw. vergossen, ausgenommen einen Bereich 19 zwischen der LED 3 und dem im Wesentlichen optisch durchlässigen Bereich 11, 11a, 11b, 11c. Das Vergießblockiermittel 17, welches vorzugsweise als Nut 18 ausgebildet ist, die auf der Innenseite des Gehäuses 10, 100 und um den im Wesentlichen optisch durchlässigen Bereich 11, 11a, 11b, 11c herum ausgebildet ist, unterbricht dazu die Kapillarwirkung zwischen Gehäuse 10, 100 und Modul 2 an den entsprechenden Stellen, sodass sich die Vergussmasse in dem gesamten Gehäuse 10, 100 ausbreitet, ausgenommen der vorgenannte Bereich 19 zwischen LED 3 und im Wesentlichen optisch durchlässigen Bereich 11, 11a, 11b, 11c. Dadurch wird gewährleistet, dass die Vergussmasse nicht zwischen LED 3 und dem im Wesentlichen optisch durchlässigen Bereich 11, 11a, 11b, 11c eindringt, wodurch ein ungehindertes Abstrahlen der LED nach außen bei gleichzeitig besonders simplem und kompaktem Aufbau des Gehäuses 10, 100 gewährleistet ist.

Vorzugsweise liegt das Modul 2 plan auf der Innenseite des Gehäuses 10, 100 auf, auf der sich auch das Vergießblockiermittel 17 befindet. Somit wird ein Eindringen von Vergussmasse zusätzlich erschwert.

In jedem Fall kann auf besonders einfache Weise und direkt nach dem Einlegen des Moduls 2 in das Gehäuse 10,100 das Gehäuse 10, 100 ausgegossen werden, ohne das Modul 2 in besonderer Weise zu befestigen, wobei dennoch keine Vergussmasse in den Bereich 19 eindringt. Die eingebrachte Vergussmasse bildet einen Vergusskörper 30, der das Gehäuse 10, 100, das Modul 2 sowie die Anschlusskabel 20 sicher und in nach außen abdichtender Weise umgibt und verbindet. Der Vergusskörper 30 dient dabei zudem als weitere Zugentlastung für die Anschlusskabel 20.

Die Erfindung ist nicht auf obige Ausführungsbeispiele beschränkt. Jede Kombination der in den Ausführungsbeispielen genannten Merkmale und Eigenschaften sind beliebig kombinierbar.

## Patentansprüche

1. Gehäustes LED-Modul aufweisend:
- ein Modul (2) mit wenigstens einer darauf angeordneten LED (3),
- ein einteiliges Gehäuse (10, 100) mit einer Aufnahme für das Modul (2), einem im Wesentlichen optisch durchlässigen Bereich (11, 11a, 11b, 11c), welcher das Abstrahlen von Licht der LED (3) nach außen ermöglicht und einer Öffnung (16), und
- ein Vergießblockiermittel (17), welches zwischen dem Modul (2) und dem Gehäuse (10, 100) angeordnet ist,
wobei das Vergießblockiermittel (17) derart ausgebildet ist, dass es das Eindringen einer über die Öffnung (16) in das mit dem Modul (2) bestückte Gehäuse (10, 100) eingebrachten Vergussmasse in einen Bereich (19) zwischen LED (3) und den im Wesentlichen optisch durchlässigen Bereich (11, 11a, 11b, 11c), durch Aufhebung der Kapillarwirkung zwischen Modul (2) und Gehäuse (10, 100) verhindert,
**dadurch gekennzeichnet, dass** das Vergießblockiermittel (17) eine Nut (18) aufweist, welche auf der Innenseite des Gehäuses (10, 00) und um den im Wesentlichen optisch durchlässigen Bereich (11, 11a, 11b, 11c) herum ausgebildet ist, um die Kapillarwirkung zwischen Gehäuse (10,100) und Modul (2) zu unterbrechen.

2. Gehäustes LED-Modul nach Anspruch 1, wobei die eingebrachte Vergussmasse einen Vergusskörper (30) bildet, der das Gehäuse (10, 100), aufgrund der Vergießblockiermittel (17) ausgenommen den Bereich (19) zwischen LED (3) und den im Wesentlichen optisch durchlässigen Bereich (11, 11a, 11b, 11c), vollständig ausfüllt und der das Gehäuse (10, 100), das Modul (2) sowie mit dem Modul (2) verbindbare Anschlusskabel (20) in nach außen abdichtender Weise verbindet.

3. Gehäustes LED-Modul nach einem der vorhergehenden Ansprüche, wobei das Modul (2) über die Öffnung (16) in das Gehäuse (10, 100) einbringbar ist.

4. Gehäustes LED-Modul nach einem der vorhergehenden Ansprüche, wobei die Vergießblockiermittel (17) ein integraler Bestandteil des Moduls (2) und/oder des Gehäuses (10) sind.

5. Gehäustes LED-Modul nach einem der vorhergehenden Ansprüche, wobei der im Wesentlichen optisch durchlässigen Bereich (11) mehrere im Wesentlichen optisch durchlässigen Bereiche (11a, 11b, 11c) aufweist.

6. Gehäustes LED-Modul nach Anspruch 1 bis 5, wobei die Nut (18) um die Gesamtheit der im Wesentlichen optisch durchlässigen Bereiche (11a, 11b, 11c) herum ausgebildet ist.

7. Gehäustes LED-Modul nach Anspruch 5, wobei die jeweiligen im Wesentlichen optisch durchlässigen Bereiche (11a, 11b, 11c) einzeln oder in Gruppen jeweils mit einem eigenen, unabhängigen Vergießblockierungsmittel (17) versehen sind, das beispielsweise als umlaufende Nut 18 ausgebildet jeweils um einen oder eine entsprechende Gruppe von im Wesentlichen optisch durchlässigen Bereichen (11a, 11b, 11c) herum ausgebildet ist.

8. Gehäustes LED-Modul nach einem der Ansprüche 5 bis 7, wobei die im Wesentlichen optisch durchlässigen Bereiche (11a, 11b, 11c) in einer linearen Anordnung vorgesehen sind oder wenigstens einer der im Wesentlichen optisch durchlässigen Bereiche (11a, 11b) zu wenigstens einem anderen im Wesentlichen optisch durchlässigen Bereich (11c) versetzt vorgesehen ist.

9. Gehäustes LED-Modul nach einem der Ansprüche 1 bis 8, wobei das Modul (2) plan auf der die Nut (18) aufweisenden Seite des Gehäuses (10, 100) aufliegt.

10. Gehäustes LED-Modul nach einem der vorhergehenden Ansprüche, wobei die Vergussmasse ein Material mit hoher Wärmeleitfähigkeit aufweist, wie beispielsweise Polyurethan, Silikonharz oder Epoxydharz, und wobei die Wärmeleitfähigkeit vorzugsweise höher als 0.3 W/(m*K), mehr bevorzugt höher als 0.5 W/(m*K) ist.

11. Verfahren zur Herstellung eines gehäusten LED-Moduls, aufweisend die folgenden Schritte:
- Einbringen eines Moduls (2) mit wenigstens einer darauf angeordneten LED (3) in eine Aufnahme eines einteiligen Gehäuses (10,100) aufweisend einen im Wesentlichen optisch durchlässigen Bereich (11, 11a, 11b, 11c), welcher das Abstrahlen von Licht der LED (3) nach außen ermöglicht und eine Öffnung (16),
- Elektrische Kontaktierung von dem Modul (2) mit Anschlusskabeln (20),
- Einbringen einer Vergussmasse über die Öffnung (16) in das mit dem Modul (2) bestückte Gehäuse (10, 100), wobei ein Vergießblockiermittel (17), welches zwischen dem Modul (2) und dem Gehäuse (10, 100) angeordnet ist, ein Eindringen der Vergussmasse in einen Bereich (19) zwischen LED (3) und den im Wesentlichen optisch durchlässigen Bereich (11, 11a, 11b, 11c) durch Aufhebung der Kapillarwirkung zwischen Modul (2) und Gehäuse (10, 100) verhindert, **dadurch gekennzeichnet, dass** das Vergießblockiermittel (17) eine Nut (18) aufweist, welche auf der Innenseite des Gehäuses (10, 100) und um den im Wesentlichen optisch durchlässigen Bereich (11, 11a, 11b, 11c) herum ausgebildet ist, wobei die Nut (18) beim Einbringen der Vergussmasse die Kapillarwirkung zwischen Gehäuse (10, 100) und Modul (2) unterbricht.

12. Verfahren nach Anspruch 11, wobei die eingebrachte Vergussmasse einen Vergusskörper (30) bildet, der das Gehäuse (10, 100), aufgrund der Vergießblockiermittel (17) ausgenommen ein Bereich (19) zwischen LED (3) und den im Wesentlichen optisch durchlässigen Bereich (11, 11a, 11b, 11c), vollständig ausfüllt und der das Gehäuse (10, 100), das Modul (2) sowie die Anschlusskabel (20) in nach außen abdichtender Weise verbindet.

13. Verfahren nach einem der Ansprüche 11 oder 12, wobei das Modul (2) über die Öffnung (16) des Gehäuses (10, 100) in das Gehäuse (10, 100) eingebracht wird.

14. Verfahren nach einem der Ansprüche 11 bis 13, wobei die Vergussmasse mittels eines Zwei- oder Mehrkomponenten-Spritzsystems eingebracht bzw. eingespritzt wird.

15. Gehäustes LED-System aufweisend ein gehäustes LED-Modul nach einem der Ansprüche 1 bis 10, sowie Anschlusskabel (20), welche mit dem Modul (2) elektrisch kontaktiert sind.

16. LED-Kette aufweisend wenigstens zwei der gehäusten LED-Module (1) nach Anspruch 1 bis 10, wobei die gehäusten LED-Module (1) an beliebigen Positionen auf Anschlusskabeln (20) montiert sind, und wobei die Anschlusskabel (20) vorzugsweise flexibel ausgebildet sind.

## Claims

1. Housed LED module comprising:
- module (2) with at least one LED mounted thereon (3),
- a one-part housing (10, 100) with a receptacle for the module (2), a substantially optically permeable region (11, 11a, 11b, 11c), which enables the emission of light from the LED (3) to the outside and an opening (16), and
- a molded blocking device (17) which is disposed between the module (2) and the housing (10,100),
wherein the molded blocking device (17) is so designed that it prevents the penetration of a casting compound via the opening (16) into the housing (10, 100) fitted in the module (2) in a region (19) between the LED (3) and the substantially optically permeable region (11, 11a, 11b, 11c) by interrupting the capillary action between the module (2) and the housing (10, 100),
**characterized in that** the molded blocking device (17) has a groove (18) formed on the inside of the housing (10, 100) and around the substantially optically permeable region (11, 11a, 11b, 11c) in order to interrupt the capillary action between the housing (10, 100) and the module (2).

2. Housed LED module according to claim 1, wherein the casting compound introduced forms a cast body (30), which completely fills the housing (10, 100) due to the molded blocking device (17) except for the region (19) between the LED (3) and the substantially optically permeable region (11, 11a, 11b, 11c), and which binds the housing (10, 100), the module (2) as well as the cable (20) connectable to the module (2), in a sealed manner against the outside.

3. Housed LED module according to one of the preceding claims wherein the module (2) can be inserted into the housing (10, 100) via the opening (16).

4. Housed LED module according to one of the preceding claims, wherein the molded blocking device (17) is an integral part of the module (2) and or of the housing (10).

5. Housed LED module according to one of the preceding claims, wherein the substantially optically permeable region (11) comprises a plurality of substantially optically permeable regions (11a, 11b, 11c).

6. Housed LED module according to claim 1 to 5, wherein the groove (18) is formed around the whole of the substantially optically permeable regions (11a, 11b, 11c).

7. Housed LED module according to claim 5, wherein the respective substantially optically permeable regions (11a, 11b, 11c) are each provided individually or in groups with its own independent molded blocking device (17), which are respectively formed, for example, as circumferential grooves 18 about corresponding groups of substantially optically permeable regions (11a, 11b, 11c).

8. Housed LED module according to one of the claims 5 to 7, wherein the substantially optically permeable regions (11a, 11b, 11c) are provided in a linear array, or at least one of the substantially optically permeable regions (11a, 11b) is offset to at least one other substantially optically permeable region (11c).

9. Housed LED module according to one of the claims 1 to 8, wherein the module (2) rests flat on the side of the housing (10, 100) with the groove (18).

10. Housed LED module according to one of the preceding claims, wherein the casting compound comprises a material with high thermal conductivity, such as polyurethane, silicone resin or epoxy resin, and wherein the thermal conductivity is preferably higher than 0.3 W/(m*K), more preferably higher than 0.5 W/(m*K).

11. Method for production of a housed LED module, comprising the following steps:
- introduction of a module (2) with at least one LED (3) arranged thereon into a receptacle of a one-part housing (10, 100) comprising a substantially optically permeable region (11, 11a, 11b, 11c), which allows the emission of light from the LED (3) outwards, and an opening (16),
- electrical contact of the module (2) with connection cables (20)
- introduction of a casting compound in housing (10, 100) fitted with the module (2) via the opening (16), wherein a molded blocking device (17), which is disposed between the module (2) and the housing (10, 100), prevents penetration of the casting compound into a region (19) between the LED (3) and the substantially optically permeable region (11, 11a, 11b, 11c) by interrupting the capillary action between the module (2) and the housing (10,100), **characterized in that** the molded blocking device (17) has a groove (18) formed on the inside of the housing (10,100) and around the substantially optically permeable region (11, 11a, 11b, 11c), wherein the groove (18) interrupts capillary action between the housing (10, 100) and the module (2) during introduction of the sealing compound.

12. Method according to claim 11, wherein the casting compound introduced forms a cast body (30), which completely fills the housing (10, 100) due to the molded blocking device (17) except for the region (19) between the LED (3) and the substantially optically permeable region (11, 11a, 11b, 11c), and which binds the housing (10,100), the module (2), as well as the connection cable (20) in a sealed manner against the outside.

13. Method according to any one of the claims 11 to 12, wherein the module (2) is introduced into the housing (10, 100) via the opening (16) of the housing (10, 100).

14. Method according to any one of the claims 11 to 13, wherein the casting compound is introduced or injected by a device of a two or multi-component injection-molding system.

15. Housed LED system comprises a housed LED module according to one of the claims 1 to 10 as well as a connection cable (20), which are electrically contacted with the module (2).

16. LED chain comprises at least two of the housed LED modules (1) according to claim 1 to 10, wherein the housed LED modules (1) are mounted at arbitrary positions on connection cables (20), and wherein the connection cables (20) are preferably designed to be flexible.

## Revendications

1. Module LED logé dans un boîtier comprenant :
- un module (2) avec au moins une LED (3) disposée dessus,
- un boîtier d'une seule pièce (10, 100), avec un logement pour le module (2), un zone (11, 11a, 11b, 11c) globalement transparente, qui permet l'émission de la lumière des LED (3) vers l'extérieur et une ouverture (16), et
- un moyen de blocage de coulage (17), qui se trouve entre le module (2) et le boîtier (10, 100), le moyen de blocage de scellement (17) étant conçu de façon à ce qu'il empêche la pénétration d'une masse de scellement insérée par l'ouverture (16) dans le boîtier (10, 100) équipé du module (2), dans une zone (19) entre la LED (3) et la zone (11, 11a, 11b, 11c) globalement transparente par suppression de l'effet capillaire entre le module (2) et le boîtier (10, 100),
**caractérisé en ce que** le moyen de blocage de scellement (17) comprend une rainure (18) qui est disposée sur le côté interne du boîtier (10, 100) et autour de la zone (11, 11a, 11b, 11c) globalement transparente, afin d'interrompre l'effet capillaire entre le boîtier (10, 100) et le module (2).

2. Module LED logé dans un boîtier selon la revendication 1, la masse de scellement insérée comprenant un corps de scellement (30), qui remplit entièrement le boîtier (10, 100), excepté la zone (19) entre la LED (3) et la zone (11, 11a,11b, 11c) globalement transparente grâce au moyen de blocage de scellement (17), et qui relie le boîtier (10, 100), le module (2) ainsi que des câbles de raccordement (20) pouvant être reliés avec le module (2) de manière étanche par rapport à l'extérieur.

3. Module LED logé dans un boîtier selon l'une des revendications précédentes, le module (2) pouvant être inséré dans le boîtier (10, 100) par l'intermédiaire de l'ouverture (16).

4. Module LED logé dans un boîtier selon l'une des revendications précédentes, les moyens de blocage de scellement (17) faisant partie intégrante du module (2) et/ou du boîtier (10).

5. Module LED logé dans un boîtier selon l'une des revendications précédentes, la zone (11) globalement transparente comprenant plusieurs zones (11a, 11b, 11c) globalement transparentes.

6. Module LED logé dans un boîtier selon la revendication 1 à 5, la rainure (18) étant disposée autour de l'ensemble des zones (11a, 11b, 11c) globalement transparentes.

7. Module LED logé dans un boîtier selon la revendication 5, les zones (11a, 11b, 11c) étant munies chacune individuellement ou par groupes d'un moyen de blocage de scellement (17) indépendant, qui est par exemple réalisée comme une rainure circulaire (18), disposée autour d'une zone ou d'un groupe correspondant de zones (11a, 11b, 11c) globalement transparentes.

8. Module LED logé dans un boîtier selon l'une des revendications 5 à 7, les zones (11a, 11b, 11c) globalement transparentes étant réalisées dans une disposition linéaire et ou au moins une des zones (11a, 11b) globalement transparentes étant disposée de manière décalée par rapport à une autre zone (11c) globalement transparente.

9. Module LED logé dans un boîtier selon l'une des revendications 1 à 8, le module (2) reposant de manière plane sur le côté du boîtier (10, 100) comprenant la rainure (18).

10. Module LED logé dans un boîtier selon l'une des revendications précédentes, le masse de scellement comprenant un matériau avec une conductivité thermique élevée, par exemple du polyuréthane, de la résine au silicone, ou de la résine époxy et la conductivité thermique étant de préférence supérieure à 0,3 W/(m*K), de préférence supérieure à 0,5 W/(m*K).

11. Procédé de fabrication d'un module LED logé dans un boîtier, comprenant les étapes suivantes :
- insertion d'un module (2), avec au moins une LED (3) disposée dessus, dans un logement d'un boîtier d'une seule pièce (10, 100) comprenant une zone (11, 11a, 11b, 11c) globalement transparente qui permet l'émission de la lumière des LED (3) vers l'extérieur et une ouverture (16),
- branchement électrique du module (2) avec des câbles de raccordement (20),
- insertion d'une masse de scellement par l'ouverture (16) dans le boîtier (10, 100) équipé du module (2), un moyen de blocage de scellement (17), qui se trouve entre le module (2) et le boîtier (10, 100), empêchant une pénétration de la masse de scellement dans une zone (19) entre la LED (3) et la zone (11, 11a, 11b, 11c) globalement transparente par suppression de l'effet capillaire entre le module (2) et le boîtier (10, 100), **caractérisé en ce que** le moyen de blocage de scellement (17) présente une rainure (18) qui est réalisée sur le côté interne du boîtier (10, 100) et autour de la zone (11, 11a, 11b, 11c) globalement transparente, la rainure (18) interrompant l'effet capillaire entre le boîtier (10, 100) et le module (2) lors de l'insertion de la masse de scellement.

12. Procédé selon la revendication 11, la masse de scellement insérée formant un corps de scellement (30) qui remplit entièrement le boîtier (10, 100), excepté une zone (19) entre la LED (3) et la zone (11, 11a, 11b, 11c) globalement transparente, grâce aux moyens de blocage de scellement (17), et qui relie le boîtier (10, 100), le module (2) ainsi que les câbles de raccordement (20) de manière étanche par rapport à l'extérieur.

13. Procédé selon l'une des revendications 11 ou 12, le module (2) étant inséré par l'ouverture (16) du boîtier (10, 100) dans le boîtier (10,100).

14. Procédé selon l'une des revendications 11 à 13, la masse de scellement étant insérée ou injectée au moyen d'un système d'injection bi- ou multi-composant.

15. Système LED logé dans un boîtier comprenant un module LEF logé dans un boîtier selon l'une des revendications 1 à 10 ainsi que des câbles de raccordement (20) qui sont connectés électriquement avec le module (2).

16. Chaîne de LED comprenant au moins deux des modules LED (1) logés dans des boîtiers selon la revendication 1 à 10, les modules LED (1) logé dans des boîtiers étant montés au niveau de positions quelconques sur les câbles de raccordement (20) et les câbles de raccordement (20) étant conçus de préférence de manière flexible.
